**Europäisches Patentamt**

**European Patent Office**

**Office européen des brevets**

(19)

(11) Veröffentlichungsnummer: **0 253 129**
**A2**

(12) # EUROPÄISCHE PATENTANMELDUNG

(21) Anmeldenummer: **87108230.1**

(22) Anmeldetag: **06.06.87**

(51) Int. Cl.⁴: **G 03 B 15/00**

(30) Priorität: **13.06.86 DE 3620017**

(43) Veröffentlichungstag der Anmeldung: **20.01.88**
Patentblatt 88/3

(84) Benannte Vertragsstaaten: **CH DE FR GB LI NL**

(71) Anmelder: **MIVATEC Hard- und Software GmbH,
Zaunackerstrasse 1, D-7022 Leinfelden-Echterdingen
(DE)**

(72) Erfinder: **Pagan, Robin, Zeisigweg 7,
D-7000 Stuttgart 80 (DE)**

(74) Vertreter: **Hoeger, Stellrecht & Partner,
Uhlandstrasse 14c, D-7000 Stuttgart 1 (DE)**

(54) **Fotoplotverfahren und Fotoplotter zum Belichten eines Films.**

(57) Die Erfindung betrifft ein Fotoplotverfahren und einen Fotoplotter zur Durchführung des Verfahrens. Gemäss der Erfindung wird ein grafisches Bildmuster in einzelne Teilbereiche unterteilt, die nacheinander auf dem Bildschirm eines Bildschirmgeräts, insbesondere einer Kathodenstrahlröhre, abgebildet und zum Belichten eines Films verwendet werden, wobei die Relativbewegung zwischen Film und Belichtungsanordnung so gesteuert wird, dass auf dem Film die einzelnen Teilbereiche mit einer gewissen Überlappung abgebildet werden. Gemäss der Erfindung hat es sich als vorteilhaft erwiesen, wenn für die im Einzelfall verwendeten Antriebs- und Positioniereinrichtungen vorab individuelle Korrekturwerte ermittelt und abgespeichert werden, um während der einzelnen Arbeitszyklen anhand der gespeicherten Daten eine Kompensation von Positionierungsfehlern zu erreichen.

ACTORUM AG

HOEGER, STELLRECHT & PARTNER

PATENTANWÄLTE

UHLANDSTRASSE 14 c · D 7000 STUTTGART 1

- *A* -

A 47 027 b  
k - 176  
10. Juni 1986

Anmelder:  
MIVATEC Hard- und Software GmbH  
Zaunackerstraße 1  
7022 Leinfelden-Echterdingen

Fotoplotverfahren und Fotoplotter  
zum Belichten eines Films

Die Erfindung betrifft ein Verfahren zum Erzeugen eines definierten grafischen Bildmusters, insbesondere des Bildes einer Leiterbahnenanordnung für eine Leiterplatte, auf einem in einer Aufzeichnungsebene befindlichen, fotoempfindlichen Film, bei dem eine Belichtungsanordnung und der Film relativ zueinander bewegt werden, um den Film mit von der Belichtungsanordnung erzeugtem Licht entsprechend dem zu erzeugenden Bildmuster zu belichten.

Es sind verschiedene Verfahren zum Herstellen von kopierfähigen Vorlagen sowie entsprechende Plotter zur Durchführung derartiger Verfahren bekannt, wobei unter Plottern, unabhängig von dem angewandten Aufzeichnungsverfahren, grundsätzlich automatisch arbeitende Zeichenmaschinen zu verstehen sind, die ihre Anweisungen entweder durch direkte Verbindungen mit einem Rechner erhalten, insbesondere einem Rechner, der nach geeigneten CAD-Programmen zum rechnergestützten Zeichnen arbeitet oder von einem transportablen Speicher (Diskette, Magnetband und dergleichen), in dem die relevanten Daten zuvor aufgezeichnet wurden.

-2-

-2-

Bei den derzeit bekannten Plottern unterscheidet man
im wesentlichen zwischen drei Typen, nämlich Papierplottern, Folienplottern und Fotoplottern.

Im einzelnen stehen für die Beschriftung von Papier
zahlreiche Papierplotter zur Verfügung, die der Erstellung technischer Zeichnungen oder anderer grafischer Darstellungen dienen, welche visuell ausgewertet
werden. Bei diesen Plottern spielt die Genauigkeit der
Zeichnungen eine untergeordnete Rolle, so daß Papierplotter relativ billig für wenige tausend Deutsche
Mark verfügbar sind. Wesentlich höhere Forderungen
werden an Folienplotter gestellt, deren Zeichnungen
auf Kunststoffolien hergestellt und dann für weitere
Prozesse verwendet werden. Ein typischer Anwendungsfall für derartige Fotoplotter ist die Herstellung
von Vorlagen für Leiterplatten für elektronische Baugruppen. Mit Hilfe eines Folienplotters besteht die
Möglichkeit, die Vorlagen für verschiedene Schichten
von Leiterplatten nacheinander derart zu zeichnen,
daß sich die einzelnen Punkte der fertigen Zeichnungen
mit hoher Präzision decken, so daß sich beispielsweise ein Lötauge eines Bauelementenanschlusses nach
der Fertigstellung einer Leiterplatte unter Verwendung der vom Plotter gezeichneten Folien auf beiden
Seiten der Leiterplatte genau an der gleichen Position befindet. Die hohe Genauigkeit der Plottermechanik sorgt in Verbindung mit der guten Maßhaltigkeit

-6-

A 47 027 b
k - 176
10. Juni 1986

-3-

der für das Zeichnen verwendeten Kunststoffolien,auf
denen mit Spezialtusche gezeichnet wird, für eine
hohe Genauigkeit der einzelnen Zeichnungen bzw. für
eine außerordentlich gute Übereinstimmung der einzelnen Bilder eines Satzes von Zeichnungen. Diese
Genauigkeit wird häufig noch dadurch verbessert, daß
man das Original der Zeichnung in einem größeren Maßstab herstellt und die Zeichnung anschließend fotooptisch verkleinert. Die Verkleinerung muß in diesem
Fall natürlich mit hoher Präzision, insbesondere mit
einer sehr genauen und teuren Reproduktionskamera
durchgeführt werden.

Die heute verfügbaren Folienplotter arbeiten mit ausreichender Präzision, um Leiterplattenzeichnungen
direkt im Maßstab 1:1 herstellen zu können, wenn die
betreffenden Leiterplatten mit Bauelementen vom "Dual-
In-Line"-Typ bestückt werden sollen. Diese Bauelemente
haben Anschlüsse in Form von Lötstiften bzw. -fahnen,
die in einem festen Raster mit einem Rastermaß von
2,54 mm angeordnet sind. Die Kosten für derartige Folienplotter bewegen sich derzeit zwischen etwa 10.000
und 45.000 DM.

Bei der Fertigung von Leiterplatten gewinnt derzeit
die sogenannte "SMD-Bestückung" (SMD = Surface Mounted
Device) zunehmend an Bedeutung. Bei dieser Technologie
lassen sich elektronische Baugruppen mit wesentlich

-7-

kleineren Abmessungen unmittelbar mit Leiterbahnen
bzw. Anschlußpunkten auf einer Seite einer Leiterplatte verlöten, deren andere Seite dann mit weiteren Bauelementen bestückt werden kann. Die Anschlüsse
der SMD-Bauelemente sind dabei gegenüber den bisher
üblichen Anschlüssen stark verkleinert und enger beieinander angeordnet. Ein wichtiger Vorteil dieser
Bauelemente besteht in ihrem geringen Platzbedarf und
in der Tatsache, daß die Leiterplatte beidseitig bestückt werden kann, da keine durchgehenden Bohrungen
für das Einlöten der Anschlüsse vorzusehen sind. Andererseits sind die Abstände zwischen den Leiterbahnen
und die Breite derselben wesentlich kleiner als bei
der Verwendung von DIL-Bauelementen, und selbst bei
Durchführungen zum Verbinden von Leiterbahnen auf
gegenüberliegenden Plattenseiten bzw. zur Herstellung
von Verbindungen zu inneren Leiterbahnen bei mehrlagigen Leiterplatten gilt ein Durchmesser von nur
0,3 mm für die betreffenden Kontaktbereiche derzeit
als Standard, und es ist leicht einzusehen, daß hier
die Präzision von direkt mit entsprechenden Stiften
auf einer Kunststoffolie zeichnenden Plottern bei
weitem nicht ausreichend genau ist.

Den erhöhten Anforderungen an die Genauigkeit beim
Arbeiten mit SMD-Bauelementen genügen derzeit lediglich Fotoplotter, bei denen eine kontinuierlich oder
intermittierend arbeitende Lichtquelle, bei der es
sich beispielsweise auch um eine Lasterlichtquelle
handeln kann, gegebenenfalls

-8-

A 47 027 b
k - 176
10. Juni 1986

-5-

in Verbindung mit Blenden, zum Belichten eine fotoempfindlichen Films mit dem gewünschten Bildmuster
verwendet wird. Dabei kann die Lichtquelle mittels
technisch aufwendiger Transportmechanismen, insbesondere in Form von Kreuzschlitten bzw. -tischen
praktisch spielfrei über einen großen Zeichenbereich
bewegt werden. Die Genauigkeit des dabei erhaltenen
Lichtabbilds auf dem Film ist abhängig von der Genauigkeit der Transporteinrichtungen für die Lichtquelle
und von der optischen Qualität derselben. Die hohen
Genauigkeitsforderungen haben bei den derzeit verfügbaren bekannten Fotoplottern entsprechend hohe Preise
zwischen etwa 90.000 DM und 250.000 DM zur Folge, wobei für Spezialgeräte mit Preisen bis zu nahezu
1 Million US-$ zu rechnen ist.

Ausgehend von dem vorstehend beschriebenen Stand der
Technik liegt der Erfindung die Aufgabe zugrunde,
das bekannte Belichtungsverfahren bzw. die bekannten
Fotoplotter dahingehend zu verbessern, daß bei gleichbleibend hoher Präzision der auf dem Film erzeugten
Abbildung die Kosten deutlich verringert sind.

Diese Aufgabe wird bei dem Verfahren der eingangs angegebenen Art gemäß der Erfindung dadurch gelöst, daß
für die Belichtungsanordnung der Bildschirm eines Bildschirmgeräts verwendet wird, daß auf dem Bildschirm
jeweils ein vorgegebener Teilbereich des definierten
Bildmusters erzeugt wird, daß die Relativbewegung von

-6-

Film und Belichtungsanordnung schrittweise gemäß einer
vorgegebenen Schrittfolge herbeigeführt wird und daß
die Erzeugung der einzelnen Teilbereiche auf dem Bildschirm und die Relativbewegung von Film und Belichtungsanordnung derart koordiniert gesteuert werden, daß das
Bildmuster auf dem Film aus den Abbildern der einzelnen
Teilbereiche zusammengesetzt wird.

Dabei ist es vorteilhaft, wenn der fotoempfindliche
Film während der Herstellung der Aufzeichnung in der
Zeichenebene festgelegt ist und wenn sich nur die
Lichtquelle gegenüber dem Film bewegt.

Es besteht aber auch die Möglichkeit, den Film gegenüber der Lichtquelle schrittweise zu verfahren oder
Bewegungen der Lichtquelle einerseits und des Films
andererseits derart zu kombinieren, daß der Film entsprechend der gewünschten Vorlage belichtet werden
kann.

Zur Durchführung des erfindungsgemäßen Verfahrens
wird vorzugsweise ein Fotoplotter mit einer mittels
einer Kreuzschlittenanordnung relativ zu einer Aufzeichnungsebene verfahrbaren Belichtungsanordnung
zum Belichten eines in der Aufzeichnungsebene befindlichen Films mit einem definierten Bildmuster verwendet, der dadurch gekennzeichnet ist, daß die Belichtungsanordnung ein Bildschirmgerät , insbesondere eine
Kathodenstrahlröhre umfasst, auf

A 47 027 b
k - 176
10. Juni 1986

- 7 -

deren Bildschirm das Bild vorgegebener Teilbereiche
des Bildmusters zur Belichtung des Films erzeugbar
ist und die durch den Kreuzschlitten in einer vorgegebenen Schrittfolge über die den Teilbereichen entsprechenden Filmbereich verfahrbar ist, um die Filmbereiche nacheinander mit den Abbildern der zugeordneten Teilbereiche zu belichten.

Es ist ein wesentlicher Vorteil des Verfahrens und
des Fotoplotters gemäß der Erfindung, daß beim Belichten des Films einzelne Teilbereiche des Bildmusters nacheinander mit großer Präzision erzeugt werden können, da durch die Verwendung eines Bildschirmgeräts sehr weitgehend die große Genauigkeit ausgenutzt werden kann, die sich bei der Bilderzeugung mit
gespeicherten digitalen Daten ergibt. Die Präzision
des auf dem Bildschirm des Bildschirmgeräts erzeugten
Bildes kann dabei dadurch noch weiter verbessert werden, daß man die Bildausschnitte nur in einem begrenzten inneren Bereich des Bildschirms erzeugt, in
dem keinerlei Verzerrungen durch die Röhrengeometrie
zu befürchten sind.

In vorteilhafter Ausgestaltung der Erfindung hat es
sich ferner als günstig erwiesen, wenn zwischen dem
Bildschirm des Bildschirmgeräts und dem Film ein gemeinsam mit dem Bildschirmgerät verfahrbares Objektiv
zur Verkleinerung des Abbildmaßstabs des Bildschirmbildes bei dessen Übertragung auf den Film vorgesehen

A 47 027 b
k - 176
10. Juni 1986

- 8 -

ist. Bei dieser Ausgestaltung ergibt sich nämlich
einerseits durch die Verkleinerung eine verbesserte
Auflösung, während andererseits wegen der geringen
Größe der abzubildenden Bildbereiche keine extremen
Forderungen an die Qualität des Objektivs gestellt
werden müssen, wie dies bei Repro-Kameras der Fall
ist, mit denen in einem einzigen Belichtungsschritt
eine vollständige Vorlage auf einem Film abgebildet
wird.

Als vorteilhaft hat es sich auch erwiesen, wenn die
Steuerung des Kreuzschlittens zur exakten Positionierung des Bildschirmgeräts, insbesondere der Kathodenstrahlröhre, über dem jeweils anzufahrenden Filmbereich in Abhängigkeit von für den betreffenden Kreuztisch individuell gemessenen Positionierdaten durchführbar ist. Durch diese Maßnahme wird nämlich die
Präzision der auf dem Film erhaltenen Abbildung noch
weiter verbessert, da Abweichungen von der genauen
Position beim Anfahren der verschiedenen Positionen
des Kreuzschlittens dadurch praktisch vollständig
kompensiert werden können, daß bei einem Probelauf
bzw. Eichlauf entsprechende Positionier- bzw. Korrekturdaten abgespeichert werden. Auf diese Weise lassen
sich dann selbst kleinste Ungenauigkeiten des mechanischen Antriebs der Kreuzschlittenanordnung beim Belichten des Films mit einem definierten Bildmuster
berücksichtigen. Die Möglichkeit des Messens und der
Abspeicherung von individuellen Korrekturdaten für

-12-

- 9 -

jede der von dem Kreuztisch nacheinander anzufahrenden
Positionen ist dabei eng mit der Unterteilung des
Bildmusters in eine begrenzte Anzahl von Teilbereichen
verknüpft, da diese Anzahl auf jeden Fall deutlich
geringer ist als die Anzahl der bei konventionellen
Fotoplottern anzufahrenden Bildpunkte.

Die Erfindung wird nachstehend anhand von Zeichnungen
noch näher erläutert. Es zeigen:

Fig. 1        ein schematisches Blockschaltbild
              der wesentlichen Elemente der Steue-
              rung eines Fotoplotters zur Durch-
              führung des erfindungsgemäßen Ver-
              fahrens        und

Fig. 2        eine schematische Darstellung zur
              Verdeutlichung der Arbeitsweise beim
              schrittweisen Erzeugen eines Bildmusters nach dem erfindungsgemäßen
              Verfahrens.

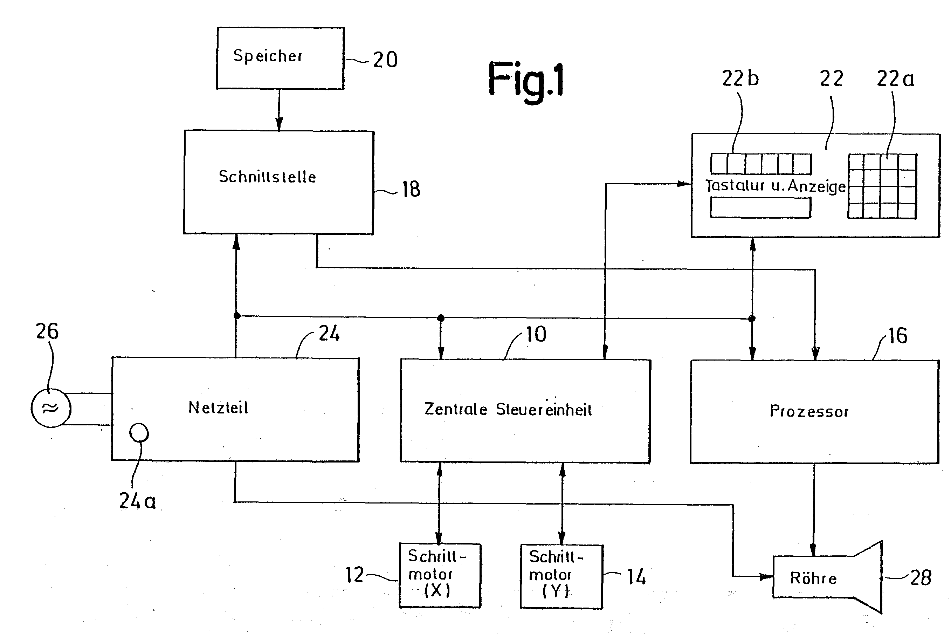

Im einzelnen zeigt Fig. 1 eine Steuerung mit einer
zentralen Steuereinheit 10 (controller), welche der
Steuerung zweier Schrittmotoren 12,14 dient, die in
üblicher Weise dem Antrieb eines Kreuzschlittens in
X-Richtung bzw. in Y-Richtung dienen. Die Schrittmotoren 12,14, denen üblicherweise Treiberstufen
(nicht dargestellt) vorgeschaltet sind, empfangen
dabei nicht nur Steuersignale von der zentralen

A 47 027 b
k - 176
10. Juni 1986

- *10* -

Steuereinheit 10, sondern senden an diese auch ihre
Positionsdaten zurück, so daß in der Steuereinheit
ein Vergleich zwischen den Positions-Istwerten und
den entsprechenden Sollwerten durchgeführt werden
kann. Die Tatsache, daß die Signalübertragung zwischen den Schrittmotoren 12 und 14 einerseits und
der Steuereinheit 10 andererseits in beiden Richtungen
erfolgt, ist durch entsprechende Pfeile in üblicher
Weise an den Verbindungsleitungen zwischen den genannten Einheiten angedeutet. Die Steuereinheit 10
wird ihrerseits von einem Prozessor 16 angesteuert,
dem die Daten des zu erzeugenden definierten Bildmusters über eine Schnittstelle 18 aus einem Speicher
20 zugeführt werden, der als Speicherelement beispielsweise ein Magnetband oder eine Diskette enthalten kann. Auch zwischen der Steuereinheit 10 und
dem Prozessor 16 erfolgt die Datenübertragung dabei
wieder in beiden Richtungen, damit die Steuereinheit
beispielsweise das Erreichen einer neuen Position
melden kann, ehe ihr von dem Prozessor 16 weitere
Daten zugeführt werden. Außerdem ist die zentrale
Steuereinheit 10 noch mit einem Steuerfeld 22 verbunden, an dem mittels einer Tastatur 22a Start-,
Stop- und Hilfsbefehle erzeugt werden können, wobei
die betreffenden Befehlscode bzw. damit verknüpfte
Signale von der zentralen Steuereinheit 10 durch
eine Anzeigeeinheit 22b angezeigt werden können. Die
Versorgung der einzelnen Baugruppen erfolgt bei der betrachteten Steuerung mit Hilfe eines Netzteils 24,
an dem ein Netzschalter 24a vorgesehen ist und das

-14-

- *11* -

eingangsseitig mit einer Netzspannungsquelle 26 verbunden ist. Schließlich ist in Fig. 1 noch eine Belichtungsanordnung 28 gezeigt, welche ihre Versorgungsspannung vom Netzteil 24 empfängt und - im allgemeinen über eine Treiberschaltung (nicht dargestellt) - direkt von dem Prozessor 16 gesteuert wird. Gegebenenfalls kann der Speicher 20 auch Bestandteil eines Host-Rechners, insbesondere eines CAD-Systems, sein, dabei können die gespeicherten Bildmusterdaten nach dem Rasterverfahren oder nach dem Vektorverfahren gebildet werden.

Die Steuerung gemäß Fig. 1, soweit sie bis hierher beschrieben wurde, arbeitet weitgehend ebenso wie eine übliche Steuerung für einen üblichen Fotoplotter, bei dem die Belichtungsanordnung mittels einer Kreuzschlittenanordnung gegenüber einem in einer Aufzeichnungsebene befindlichen fotoempfindlichen Film verfahren wird, um auf diesem ein definiertes Bildmuster zu erzeugen.

Abweichend von dem bisher üblichen Verfahren wird jedoch erfindungsgemäß keine einfach Belichtungsanordnung verwendet, welche kontinuierlich oder intermittierend leuchtet, um den Film Punkt für Punkt zu belichten; vielmehr ist beim Ausführungsbeispiel eine Belichtungsanordnung in Form einer Kathodenstrahlröhre 28 vorgesehen, auf deren Bildschirm in Abhängigkeit von den aus dem Speicher 20 gelieferten Daten

-12-

mit Hilfe des Prozessors 16 jeweils das Bildmuster
für einen vorgegebenen Teilbereich erzeugt wird. Außerdem werden die Schrittmotoren 12,14 von der zentralen
Steuereinheit 10 derart angesteuert, daß sie die Kathodenstrahlröhre 28 nacheinander in die den einzelnen
Teilbereichen entsprechenden Positionen verfahren,
wo die Kathodenstrahlröhre 28 dann für eine für den
Belichtungsvorgang ausreichende Zeit angehalten wird.
Da auf diese Weise nur eine im Vergleich zu den einzelnen Bildpunktpositionen geringe Anzahl von Belichtungspositionen angefahren werden muß, ergibt sich
bei der erfindungsgemäßen Steuerung ferner die Möglichkeit, in einer Speichereinheit des Prozessors
oder der zentralen Steuereinheit korrigierte Positionswerte bzw. Korrekturwerte abzuspeichern, die bei einem
Probe- bzw. Eichlauf ermittelt werden - es wird also
zunächst ein sogenannter Teach-in-Zyklus durchgeführt -
so daß selbst kleinste Ungenauigkeiten der Schlittenantriebe kompensiert werden können, bei denen es sich
normalerweise um Gewindespindeln handelt, auf denen
Kugelgewindemuttern spielfrei und reibungsarm laufen.

Die Ansteuerung der Kathodenstrahlröhre 28 einerseits
und die Ansteuerung der Schrittmotoren 12,14 andererseits erfolgt ferner bei dem erfindungsgemäßen Verfahren vorzugsweise derart, daß sich die einzelnen Teil- bzw.
Bildbereiche jeweils um ein Bildelement (Pixel) überlappen, damit beim Belichten des Films durchgehende
Linienzüge ohne Unterbrechungen an den Grenzen zwischen benachbarten Bildbereichen erhalten werden.

A 47 027 b
k - 176
10. Juni 1986

-13-

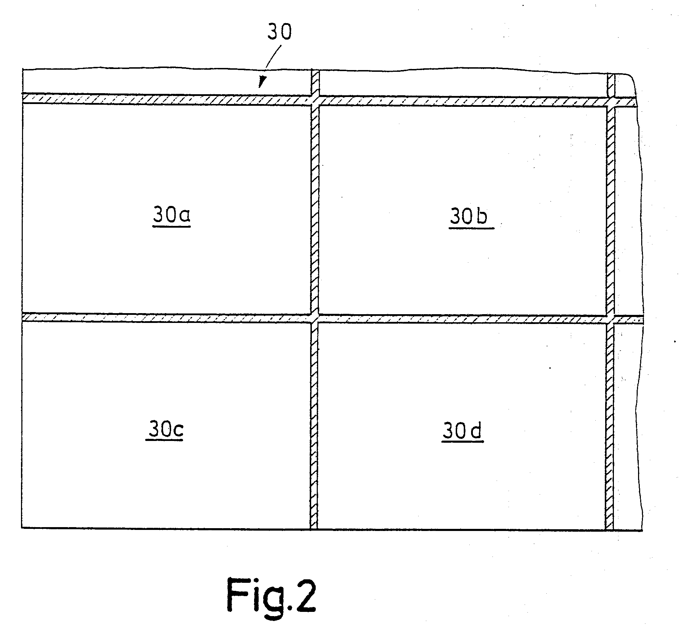

Speziell zeigt Fig. 2 einen Filmausschnitt 30 mit vier Bildbereichen 30a bis 30d, wobei die Überlappungsbereiche
an den Grenzen zwischen den Bildbereichen durch eine
Schraffur hervorgehoben sind.

Beim Arbeiten nach dem erfindungsgemäßen Verfahren
wird vorzugsweise nur der innere Teil des Bildschirms
der Kathodenstrahlröhre 28 zur Erzeugung der Abbildung
der einzelnen Bildbereiche verwendet, um Ungenauigkeiten aufgrund von Randverzerrungen der Kathodenstrahlröhre zu vermeiden. Die Bildqualität kann dabei
noch weiter dadurch erhöht werden, daß zwischen dem
Bildschirm der Kathodenstrahlröhre 28 und dem zu belichtenden Film eine verkleinernde Optik eingesetzt wird.

Während beim Ausführungsbeispiel die einzelnen Teilbereiche des auf dem Film abzubildenden grafischen
Bildmusters auf dem Bildschirm einer Kathodenstrahlröhre erzeugt werden, versteht es sich, daß auch andere, mit einem mehr oder weniger flachen Bildschirm
arbeitende Bildschirmgeräte eingesetzt werden können,
beispielsweise Plasma-Bildschirmgeräte, Bildschirmgeräte mit einem Raster von Dioden usw. Dabei ist es
wichtig, daß die Helligkeit an den einzelnen Punkten
des Bildschirms ausreichend ist, um den jeweils verwendeten Film innerhalb angemessener Zeit ausreichend
zu belichten.

Weiterhin versteht es sich, daß anstelle der im Zusammenhang mit dem Ausführungsbeispiel angesprochenen

-17-

A 47 027 b
k - 176
10. Juni 1986

-14-

Schrittmotoren für den Antrieb des Kreuzschlittens
auch geregelte Gleichstrommotoren mit einem Winkelcodierer im Regelkreis oder andere geeignete Antriebseinrichtungen verwendet werden können.

Wie eingangs bereits erwähnt, können ferner die auf
dem Bildschirm erzeugten Teilbereiche des grafischen
Bildmusters sowohl nach dem Rasterverfahren wie auch
nach dem Vektorverfahren erzeugt werden, so daß sich
insbesondere bei Abspeicherung der Bilddaten im Speicher eines Host-Rechners eine hohe Flexibilität für
die Einsatzmöglichkeiten des erfindungsgemäßen Fotoplotverfahrens bzw. des erfindungsgemäßen Fotoplotters
ergibt.

Abschließend soll noch einmal besonders darauf hingewiesen werden, daß eine extrem hohe Genauigkeit beim
Arbeiten mit einem erfindungsgemä0eb Fotoplotter dadurch erreichbar ist, daß die vom Kreuzschlitten anzufahrenden Koordinatenpunkte für die einzelnen Teilbereiche des kompletten grafischen Bildmusters in speziellen Probe- bzw. Eichzyklen mit hoher Genauigkeit
ermittelt werden können, wobei dem Kreuztisch individuell zugeordnete Sätze von Korrekturwerten gewonnen
werden, die für die anschließend durchzuführenden
Arbeitszyklen abgespeichert und beim Positionieren
derart berücksichtigt werden, daß unvermeidliche
Toleranzen der Spindelantriebe und dergleichen bei
den einzelnen Belichtungsschritten kompensiert werden.

---

HOEGER, STELLRECHT & PARTNER

P A T E N T A N W Ä L T E

UHLANDSTRASSE 14 c · D 7000 STUTTGART 1

A 47 027 b
k - 189
10. Juni 1986

Anmelder:
MIVATEC Hard- und Software GmbH
Zaunackerstraße 1
7022 Leinfelden-Echterdingen


Patentansprüche


1. Fotoplotverfahren zum Erzeugen eines definierten grafischen Bildmusters, insbesondere des Bildes einer Leiterbahnenanordnung für eine Leiterplatte, auf einem in einer Aufzeichnungsebene befindlichen, fotoempfindlichen Film, bei dem eine Belichtungsanordnung und der Film relativ zueinander bewegt werden, um den Film mit von der Belichtungsanordnung erzeugtem Licht entsprechend dem zu erzeugenden Bildmuster zu belichten, dadurch g e k e n n z e i c h n e t , daß für die Belichtungsanordnung der Bildschirm eines Bildschirmgeräts verwendet wird, daß auf dem Bildschirm jeweils ein vorgegebener Teilbereich des definierten Bildmusters erzeugt wird, daß die Relativbewegung von Film und Belichtungsanordnung schrittweise gemäß einer vorgegebenen Schrittfolge herbeigeführt wird und daß die Erzeugung der einzelnen Teilbereiche auf dem Bildschirm und die Relativbewegung von Film und Belichtungsanordnung derart koordiniert gesteuert werden, daß das Bildmuster auf dem Film aus den Abbildern der einzelnen Teilbereiche zusammengesetzt wird.


2. Verfahren nach Anspruch 1, dadurch gekennzeichnet, daß die Relativbewegungen von Film und Belichtungsanordnung derart gesteuert werden, daß sich die Abbilder der Teilbereiche an ihren Rändern auf einer vorgegebenen Breite überlappen.

- 2 -

3. Verfahren nach Anspruch 1 oder 2, dadurch gekennzeichnet, daß ein Bildschirmgerät mit einer Kathodenstrahlröhre verwendet wird.

4. Verfahren nach Anspruch 1, dadurch gekennzeichnet, daß
   der Bildschirm gegenüber dem feststehenden Film bewegt wird.

5. Fotoplotter mit einer mittels einer Kreuzachlittenanordnung relativ zu einer Aufzeichnungsebene verfahrbaren Belichtungsanordnung zum Belichten eines in der
   Aufzeichnungsebene befindlichen Films mit einem definierten grafischen Bildmuster zur Durchführung des
   Verfahrens gemäß Anspruch 4, dadurch gekennzeichnet,
   daß die Belichtungsanordnung ein Bildschirmgerät (28)
   umfaßt, auf dessen Bildschirm das Bild vorgegebener
   Teilbereiche des Bildmusters zur Belichtung des Films
   erzeugbar ist und das durch den Kreuzschlitten in einer
   vorgegebenen Schrittfolge über die den Teilbereichen
   (30a bis 30d) entsprechenden Filmbereiche verfahrbar
   ist, um die Filmbereiche nacheinander mit den Abbildern der zugeordneten Teilbereiche zu belichten.

6. Fotoplotter nach Anspruch 5, dadurch gekennzeichnet,
   daß zwischen dem Bildschirm des Bildschirmgeräts
   (28) und dem Film ein gemeinsam mit der Kathodenstrahlröhre verfahrbares Objektiv zur Verkleinerung
   des Abbildmaßstabs des Bildschirmbildes bei dessen
   Übertragung auf den Film vorgesehen ist.

7. Fotoplotter nach Anspruch 5 oder 6, dadurch gekennzeichnet, daß die Steuerung des Kreuzschlittens zur
exakten Positionierung. des Bildschirms über
dem jeweils anzufahrenden Filmbereich in Abhängigkeit
von für den betreffenden Kreuztisch individuell gemessene Positionierdaten durchführbar ist.

8. Fotoplotter nach einem der Ansprüche 5 bis 7, dadurch
gekennzeichnet, daß das Bildschirmgerät eine Kathodenstrahlröhre (28) umfaßt.

9. Fotoplotter nach einem der Ansprüche 1 bis 8, dadurch
gekennzeichnet, daß das Bildschirmgerät derart steuerbar ist, daß sich die Abbilder der Teilbereiche (30a
bis 30d) an ihren Rändern auf einer vorgegebenen Breite
überlappen.

Fig.1

Mivatec Hard-u.Software GmbH, Zaunackerstr.1, 7022 Leinfelden-Echterdingen

A47027b

30

Fig.2